Europäisches Patentamt

European Patent Office

Office européen des brevets

(11) Publication number: **0 430 237 A1**

# (12) EUROPEAN PATENT APPLICATION

(21) Application number: **90122850.2**

(22) Date of filing: **29.11.90**

(51) Int. Cl.⁵: **H01L 29/32**

(30) Priority: **30.11.89 JP 311333/89**

(43) Date of publication of application:
**05.06.91 Bulletin 91/23**

(84) Designated Contracting States:
**DE FR GB Bulletin 2**

(71) Applicant: **Kabushiki Kaisha Toshiba
72, Horikawa-cho Saiwai-ku
Kawasaki-shi(JP)**

(72) Inventor: **Tsunoda, Tetsujiro, c/o Intellectual
Prop. Div.
Kabushiki Kaisha Toshiba, 1-1 Shibaura
1-chome
Minato-ku, Tokyo 105(JP)**

(74) Representative: **Lehn, Werner, Dipl.-Ing. et al
Hoffmann, Eitle & Partner Patentanwälte
Arabellastrasse 4
W-8000 München 81(DE)**

(54) Bipolar device in which carrier lifetime is controlled.

(57) A bipolar type semiconductor device includes a first semiconductor region (101) of a first conductivity type, a second semiconductor region (102) of a second conductivity type formed on the main surface of the first semiconductor region, a third semiconductor region (103) of the second conductivity type formed on the main surface of the second semiconductor region, a fourth semiconductor region (104) of the first conductivity type formed in at least part of the main surface area of the third semiconductor region (103), and a fifth semiconductor region (105) of the second conductivity type formed in at least part of the main surface area of the fourth semiconductor region (104). A low carrier-lifetime layer (110) having a peak of the number of recombination centers of carriers is formed in the second semiconductor region (102). The low carrier-lifetime layer (110) is formed by irradiating high-energy particles such as protons, particles, heavy hydrogen, or hydrogen molecule ions from the rear surface side of the first semiconductor region (101). In a case where the second semiconductor region (102) is not formed, the low carrier-lifetime layer (110) is formed in that part of the third semiconductor region (103) which lies near the junction between the first semiconductor region (101) and the first semiconductor region (103).

F I G. 2

## BIPOLAR DEVICE IN WHICH CARRIER LIFETIME IS CONTROLLED

This invention relates to a semiconductor device, and more particularly to a bipolar device such as an insulated gate bipolar transistor (IGBT) or thyristor in which the lifetime of carriers is controlled by irradiating high-energy particles.

A bipolar device such as an IGBT or thyristor is widely used as a high-power switching device for controlling motors or various devices such as inverters. In such a switching device, it has been required to attain low power conversion loss, high-speed switching operation and low ON-state voltage characteristic. An increase in the switching speed causes the fall time and rise time to be shortened so that the power conversion loss may be reduced and reduce the distortion of an output signal waveform so that occurrence of noises may be suppressed. Conventionally, in order to satisfy the above requirements, the switching speed is enhanced by controlling the lifetime of carriers. That is, the recombination rate of carriers is enhanced by reducing the lifetime of carriers so as to reduce the turn-off time, thereby attaining a high-speed switching operation.

As a general method for controlling the lifetime of carriers, a method for implanting heavy metals such as gold or platinum into silicon and a method for irradiating high-energy particles such as electrons into silicon. The above methods are described in, for example, IEEE TRANSACTIONS ON ELECTRON DEVICES. VOL.ED-24, No. 6, JUNE 1977 pp. 685-688 "Comparison of Gold, platinum and Electron irradiation for Controlling Lifetime in Power Rectifiers" B.JAYANT BALIGA et al. The above methods are common in that recombination centers are formed in the entire area from the main surface of the silicon substrate to the rear surface thereof to reduce the lifetime of carriers.

In general, the switching characteristic and ON-state voltage characteristic of the bipolar device set by controlling the lifetime of carriers are set in the trade-off relation. That is, when the lifetime of carriers is set to be excessively short in order to enhance the switching speed, the ON-state voltage becomes extremely high, and when the ON-state voltage is kept at a low level, the switching speed tends to be low.

As described above, the characteristics of the device are significantly influenced by control of the lifetime of carriers. Particularly, when it is required to attain a high speed switching operation, the lifetime of carriers must be strictly controlled. In this respect, the electron irradiation method in which the lifetime of carriers can be controlled by the acceleration voltage and dose amount may be advantageous over the heavy metal implanting method in which variation in the characteristic is large in order to enhance the switching speed of the device. However, the trade-off relation between the switching characteristic and the ON-voltage characteristic in the electron irradiation method is not so good as that in the heavy metal implanting method. For this reason, it has been desired to develop a method for controlling the lifetime of carriers which has both an excellent controllability of the electron irradiation method and a good trade-off relation obtained in the heavy metal implanting method.

As a method for controlling the lifetime of carriers having the above-described advantage, a method for irradiating high-energy particles such as protons, a particles, heavy hydrogen, or hydrogen molecule ions ($H2^+$) into silicon has been proposed. This method is described in, for example, IEDM 85 pp. 162-165 "IMPROVED DYNAMIC PROPERTIES OF GTO-THYRISTOR AND DIODES BY PROTON IMPLANTATION" D.Silber et al.

This method is basically similar to the above-described electron irradiation method, but unlike the electron irradiation method in which the recombination centers are formed in the entire area ranging from the main surface of the silicon substrate to the rear surface thereof, it has a feature that the peak of the number of recombination centers of carriers can be selectively set in a particular position in the silicon substrate. Therefore, the trade-off between the switching characteristic and the ON-state voltage can be improved over that in the electron irradiation method and the heavy metal implantation method. A low carrier-lifetime layer which is selectively formed by irradiation of high-energy particles to have the peak of the number of recombination centers is formed in an area which will be most influenced by the minority carriers accumulated at the switching time. For example, it is formed in an $N^-$-type drift region of low impurity concentration in the case of an n-channel IGBT, and is formed in an $N^-$-type base region of low impurity concentration in the case of an n-channel thyristor.

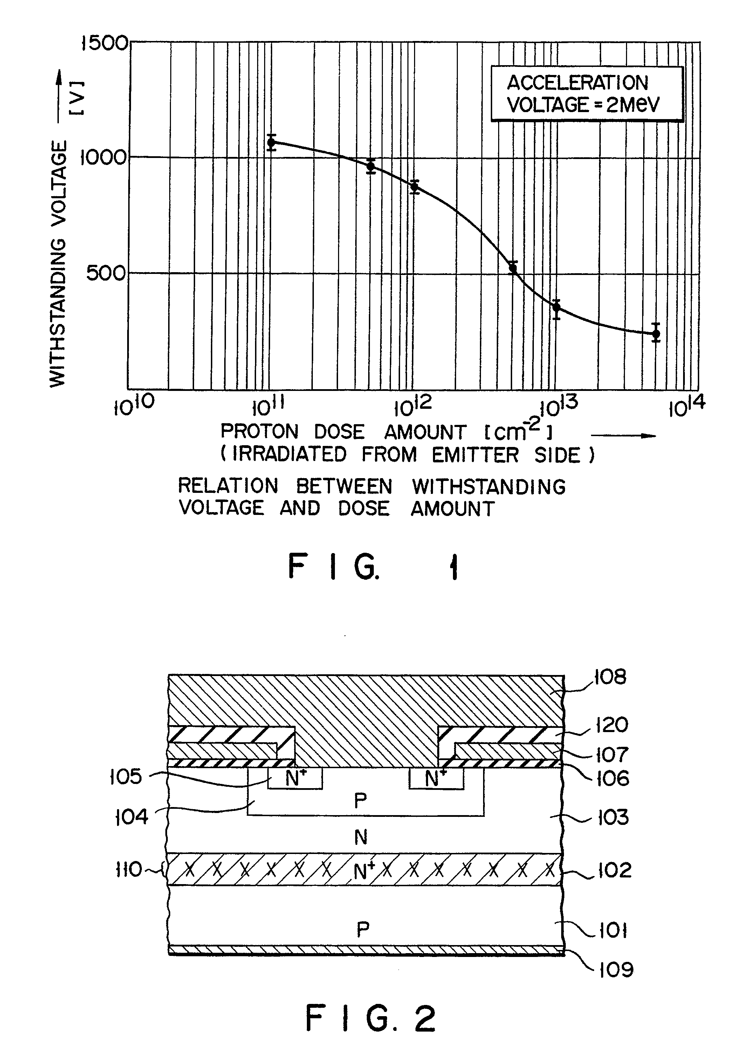

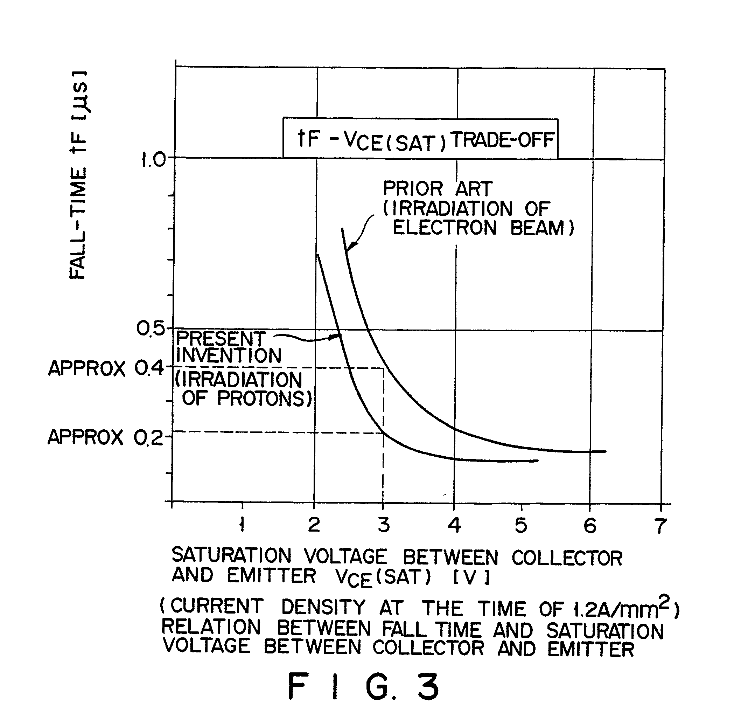

However, if the low carrier-lifetime layer is formed in the $N^-$-type drift region or $N^-$-type base region by irradiation of high-energy particles as described above, a problem that the withstanding voltage of the device will be deteriorated according to the dose amount occurs. Occurrence of the problem of deterioration of the withstanding voltage has been confirmed by the experiments made by the inventor of this application and the result of the experiment is shown in Fig. 1. Fig. 1 shows the relation between the withstanding voltage of the IGBT and the dose amount of protons obtained as the result of irradiation of protons into the n-channel IGBT from the emitter side thereof at an acceleration voltage of 2 MeV. As shown in Fig. 1, with an increase in the dose amount of protons, the withstanding voltage of the IGBT decreases.

As is clearly seen from the result of the experiment, the dose amount which can be irradiated into the silicon is limited according to the conventional carrier-lifetime controlling method by irradiation of high-energy particles so that the carrier-lifetime cannot be sufficiently reduced and therefore a sufficiently high-speed operation cannot be attained.

Accordingly, an object of this invention is to provide a semiconductor device in which the switching speed can be sufficiently enhanced without lowering the withstanding voltage of the device.

Another object of this invention is to provide a semiconductor device having an excellent trade-off between the switching characteristic and the ON-state voltage characteristic.

The above objects can be attained by a semiconductor device comprising a first semiconductor region of a first conductivity type; a second semiconductor region of a second conductivity type formed on the main surface of the first semiconductor region; a low carrier-lifetime layer formed in the second semiconductor region and having the peak of the number of recombination centers of carriers; a third semiconductor region of the second conductivity type formed on the second semiconductor region; a fourth semiconductor region of the first semiconductor region formed in at least part of the main surface area of the third semiconductor region; and a fifth semiconductor region of the second conductivity type formed in at least part of the main surface area of the fourth semiconductor region.

The low carrier-lifetime layer having the peak of the number of recombination centers of carriers is selectively formed in the second semiconductor region. Therefore, formation of defective layers in the third semiconductor region (for example, a drift region) may be suppressed and a depletion layer may extend freely even when a high voltage is applied to the device. As a result, the high-speed switching operation can be attained without lowering the withstanding voltage of the device. The trade-off between the switching characteristic and the ON-state voltage can be improved by forming the low carrier-lifetime layer by irradiation of high-energy particles such as a particles, heavy hydrogen, hydrogen molecule ions ($H_2^+$) or protons having a relatively large mass.

This invention can be more fully understood from the following detailed description when taken in conjunction with the accompanying drawings, in which:

Fig. 1 is a diagram showing the relation between the withstanding voltage of the device and the dose amount of protons;

Fig. 2 is a cross sectional view showing the main portion of an n-channel IGBT, for illustrating a semiconductor device according to a first embodiment of this invention;

Fig. 3 is a diagram showing the relation between the switching characteristic and the ON-state voltage of the n-channel IGBT shown in Fig. 2;

Fig. 4 is a diagram showing the relation between the acceleration voltage of protons and the withstanding voltage of the device and the relation between the acceleration voltage of protons and the stopping distance of protons in the device;

Fig. 5 is a cross sectional view for illustrating a modification of the n-channel IGBT shown in Fig. 2;

Fig. 6 is a cross sectional view showing the main portion of an anode short type IGBT, for illustrating a semiconductor device according to a second embodiment of this invention;

Fig. 7 is a cross sectional view for illustrating a modification of the anode short type IGBT shown in Fig. 6;

Fig. 8 is a cross sectional view showing the main portion of a GTO thyristor, for illustrating a semiconductor device according to a third embodiment of this invention;

Fig. 9 is a cross sectional view for illustrating a modification of the GTO thyristor shown in Fig. 8;

Fig. 10 is a cross sectional view showing the main portion of an anode short type GTO, for illustrating a semiconductor device according to a forth embodiment of this invention; and

Fig. 11 is a cross sectional view for illustrating a modification of the anode short type GTO shown in Fig. 10.

Fig. 2 is a cross sectional view showing the main portion of an n-channel IGBT which is a semiconductor device according to a first embodiment of this invention. An $N^+$-type buffer layer 102 with a thickness of approx. 20 $\mu$m is formed on a P-type collector (anode) region 101 with a thickness of 140 $\mu$m by an epitaxial growth technique, for example. An N-type drift region 103 is formed to a thickness of 90 $\mu$m on the $N^+$-type buffer layer 102 in the same manner by the epitaxial growth technique. The N-type drift region 103 and the $N^+$-type buffer layer 102 function as one region. In the surface area of the N-type drift region 103, impurity ions are selectively implanted to form a P-type base region 104. In the surface area of the P-type base region 104, impurity ions are selectively implanted to form an $N^+$-type source (cathode) region 105. A gate insulation film 106 is formed on parts of the N-type drift region 103, P-type base region 104 and $N^+$-type source region 105 by a thermal oxidation method. A gate electrode 107 of polysilicon or the like is formed on the gate insulation film 106. An insulation film 120 is formed on the exposed surface of the gate electrode 107. A source (cathode) electrode 108 is formed on the insulation film 120, part of the P-type base region 104 surrounded by the N$^+$-type source region 105 and part of the N$^+$-type source region 105 and the source electrode 108 is electrically connected to the P-type base region 104 and part of the N$^+$-type source region 105. A collector (anode) electrode 109 is formed on the rear surface of the P-type collector (anode) region 101.

Protons were irradiated into the n-channel IGBT with the above construction from the rear surface side of the collector region 101 under a condition of the acceleration voltage of 4 MeV and the dose amount of 5 X 10$^{12}$ cm$^{-2}$. After protons were irradiated under this condition, the peak of the number of protons stopped or the peak of the number of recombination centers was set in position at a depth of approx. 150 $\mu$m from the rear surface of the collector region 101. The position in which a low carrier-lifetime layer 110 having the peak of the number of recombination centers of carriers was formed could be confirmed by use of the evaluation method such as the spreading resistance (SR) method or deep level transient spectroscopy (DLTS) method. The peak may be set as indicated by x marks in the N$^+$-type buffer layer 102 and positioned in substantially the intermediate portion of the N$^+$-type buffer layer 102.

Fig. 3 shows the trade-off between the switching characteristic and the ON-state voltage characteristic of the n-channel IGBT with the above construction. The ordinate in Fig. 3 indicates the fall time $t_F$ or the switching characteristic and the abscissa indicates a saturation voltage $V_{CE}$(SAT) between the emitter (corresponding to the source region 105 shown in Fig. 3) and the collector or the ON-state voltage characteristic. In order to compare the device of this invention and the conventional device, the trade-off of a device which is now commercially available and formed by the electron irradiation method is also shown in Fig. 3.

For example, the fall time in the conventional device is approx. 0.4 $\mu$s when the saturation voltage is 3 V, but in the device of this invention, the fall time is improved to approx. 0.2 $\mu$s as shown in Fig. 3. This means that the operation speed is enhanced to substantially two times that of the conventional case. That is, it is proved that the trade-off in a device formed by irradiation of high-energy particles such as protons having a large mass has been improved.

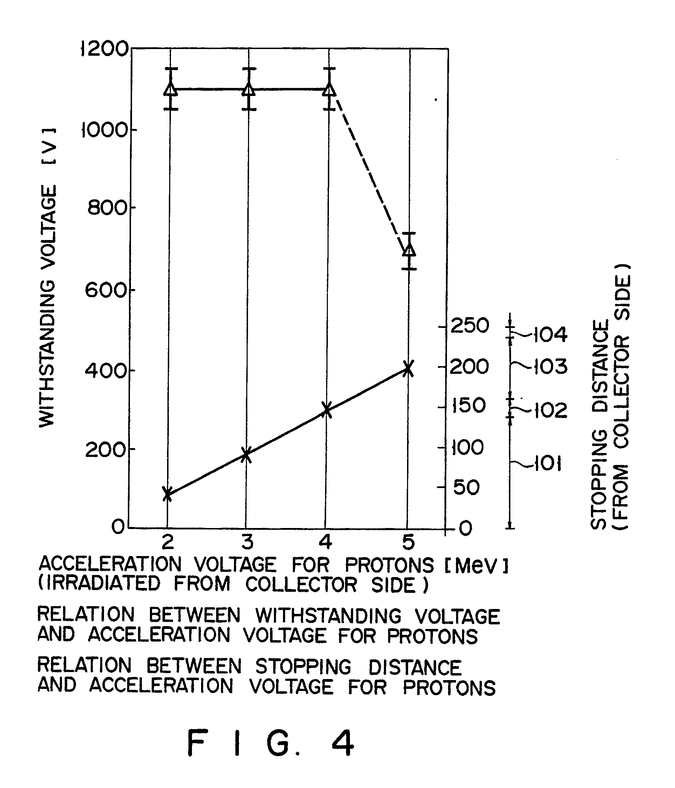

Fig. 4 shows variation in the withstanding voltage of the device caused when the acceleration voltage of protons is changed and variation in the stopping distance of protons with respect to variation in the acceleration voltage of protons. In this case, protons are irradiated from the rear surface side of the collector region in the same manner as in the first embodiment. In Fig. 4, the ordinate on the left side indicates the withstanding voltage of the device and the ordinate on the right side indicates the stopping distance of protons. In order to clearly indicate the specific position corresponding to the stopping distance in the device, corresponding reference numerals used to denote the respective areas of the device in Fig. 2 are attached to the ordinate on the right side. The abscissa indicates the acceleration voltage of protons.

As shown in Fig. 4, the stopping distance of protons in the device is substantially 50 $\mu$m when the acceleration voltage of protons is 2 MeV and the withstanding voltage obtained at this time is substantially 1100 V. Likewise, the stopping distance of protons in the device is substantially 100 $\mu$m when the acceleration voltage of protons is 3 MeV and the withstanding voltage obtained at this time is substantially 1100 V. Further, the stopping distance of protons in the device is substantially 150 $\mu$m when the acceleration voltage of protons is 4 MeV and the withstanding voltage obtained at this time is substantially 1100 V.

However, the stopping distance of protons in the device is substantially 200 $\mu$m when the acceleration voltage of protons is 5 MeV and the protons will stop in the N-type drift region 103. In this case, the withstanding voltage of the device is rapidly lowered to substantially 700 V. This phenomenon is considered to occur because the peak of the number of stopped protons is set in the N-type drift region 103 to increase the defective layer caused by irradiation of protons and suppress extension of the depletion layer by the presence of the defective layer, thereby lowering the withstanding voltage.

According to the above result, it is understood that deterioration in the withstanding voltage is observed only when the peak of the number of stopped protons is set in the N-type drift region 103 and the withstanding voltage will not be deteriorated when the peak of the number of stopped protons is set in the P-type collector region 101 or N$^+$-type buffer layer 102. However, irradiation of protons is effected to control the carrier-lifetime, and even if the peak of the number of stopped protons is set in the P-type collector region 101 just because the withstanding voltage is not deteriorated, it will not significantly contribute to control of the carrier-lifetime. Only the N$^+$-type buffer layer 102 among the regions in which the withstanding voltage is not lowered is a region which is integrally formed with the N-type drift region 103 from the viewpoint of the operation. That is, if the peak of the number of stopped protons is formed in the $N^+$-type buffer layer 102, the carrier-lifetime can be controlled by irradiation of protons having a relatively large mass without deteriorating the withstanding voltage of the device.

Now, the distribution of irradiated protons is explained.

The distribution of irradiated protons is substantially similar to the distribution of ions implanted by the ion-implantation technique which is well known in the art, and it can be considered that the distribution in the depth direction of protons irradiated in a direction deviated from the crystal axis of the semiconductor substrate may be substantially represented by Gaussian distribution. That is, the irradiated protons are spread in both depth directions from the peak of the number of stopped protons. The way of spreading varies according to the dose amount of protons, the material of the semiconductor substrate, the crystal axis of the semiconductor substrate and the like.

In this invention, the distribution of irradiated protons is also important and there is a possibility that a defective layer may be formed in the N-type drift region 103 according to the distribution state of protons although it is not so high as in the conventional case. When it is required to increase the dose amount of protons, it will be sufficient to set the peak of the number of stopped protons or the peak of the number of recombination centers in position which is deviated from the central portion in the depth direction of the $N^+$-type buffer layer 102 towards the P-type collector region 101. The dose amount can be increased to maximum when the peak of the number of stopped protons or a portion in which the carrier-lifetime is most deteriorated is set in that portion of the $N^+$-type buffer layer 102 which lies near the interface between the P-type collector region 101 and the $N^+$-type buffer layer 102. With this structure, the amount of protons lying in the N-type drift region 103 can be decreased and formation of defective layers can be suppressed, and therefore the withstanding voltage of the device will be hardly deteriorated even when the dose amount is increased.

On the other hand, when the dose amount is reduced, the peak of the number of stopped protons may be set in position which is deviated from the center in the depth direction of the $N^+$-type buffer layer 102 towards the N-type drift region 103 since the amount of protons lying in the N-type drift region 103 becomes small.

Irradiation of protons may be effected from the side of the collector 101 or from the side of the emitter 105, but it is desirable to irradiate protons from the side of the collector 103 since in this case the protons will not pass through the N-type drift region 103 when damage of the semiconductor substrate due to irradiation of protons which is a so-called irradiation damage is taken into consideration. In the above embodiment, a case wherein protons are used as high-energy particles to be irradiated is explained, but they are not limited to protons and other high-energy particles such as a particles, heavy hydrogen, hydrogen molecule ions ($H2^+$) or particles which have a sufficiently large mass so as to be stopped in the semiconductor substrate can be used.

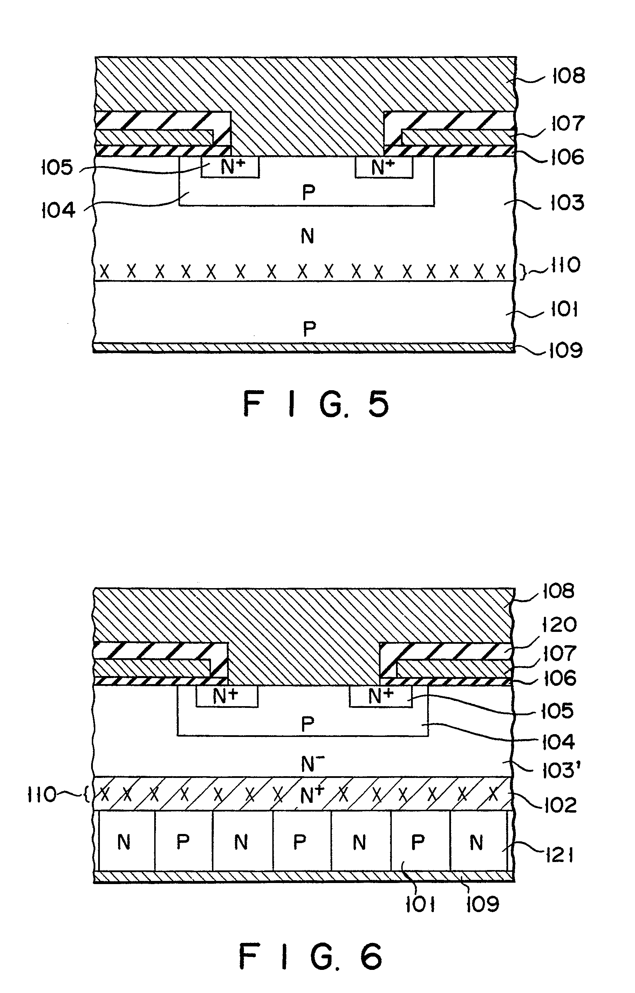

In the first embodiment, the $N^+$-type buffer layer 102 is formed between the P-type collector region 101 and the N-type drift region 103 and a low carrier-lifetime layer is selectively formed by irradiating protons into the $N^+$-type buffer layer 102. However, it is not always necessary to form the $N^+$-type buffer layer 102 in the n-channel IGBT. When the $N^+$-type buffer layer 102 is not formed, a low carrier-lifetime layer 110 in which the peak (indicated by x marks) of the number of stopped protons is set or the carrier-lifetime is most deteriorated may be formed in that part of the N-type drift region 103 which lies near the interface between the N-type drift region 103 and the P-type collector region 101 as shown in Fig. 5. With this structure, formation of defective layers in the N-type drift region 103 caused by irradiation of protons can be suppressed to minimum. Accordingly, the possibility that extension of a depletion layer from the P-type base region 104 to the N-type drift region 103 is prevented by the defective layer and the withstanding voltage of the device is lowered can be suppressed to minimum.

In Figs. 2 and 5, a case wherein the N-type drift region 103 is formed of a single layer is explained, but it may be formed of a plurality of layers having different impurity concentrations without departing from the technical scope of this invention. Further, the impurity concentration of that part of the N-type drift region 103 which lies near the junction plane between it and the P-type base region 104 may be set to be higher.

This invention is not only applied to the above-described n-channel IGBT but also applied to any bipolar device such as the other IGBTs (for example, anode short type IGBT) and thyristors (for example, GTO thyristor, optical thyristor, static induction (S1) type thyristor) having an N-type base region or N-type drift region to attain the same effect as that obtained in the first embodiment. Examples in which this invention is applied to an anode short type IGBT, a GTO thyristor and an anode short type GTO among the bipolar devices are explained as the second to forth embodiments.

Fig. 6 is a cross sectional view showing the main portions of the anode short type IGBT. In Fig. 6, those portions which are the same as the elements shown in Fig. 2 are denoted by the same reference numerals and the explanation thereof is omitted. That is, the anode sort type IGBT is similar to the IGBT of Fig. 2 except that an N⁻-type drift region 103' is formed instead of the N-type drift region 103 and a short region 121 for short-circuiting the collector electrode 109 to the N⁺-type buffer region 102 and the N⁻-type drift region 103' is formed in the P-type collector region 101.

With the above construction, sweep-off time for the minority carriers (in this example, holes) injected from the P-type collector region 101 can be shortened, and as a result, the turn-off time becomes shorter, thus further enhancing the switching operation speed.

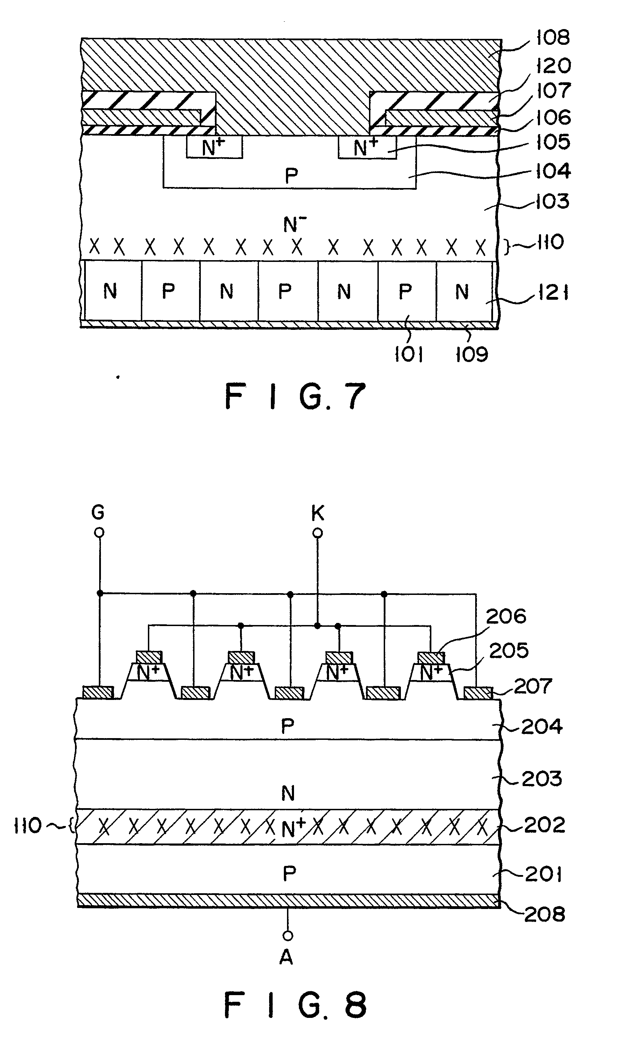

The IGBT is different from that of Fig. 2 only in the above-described respect, and the basic operation, effect and modifications are substantially the same as those of the IGBT shown in Fig. 2. Therefore, as shown in Fig. 7, it is not always necessary to form the N⁺-type buffer region 102 in the anode short type IGBT. In this case, the peak of the number of stopped protons (low carrier-lifetime layer 110) may be formed in the N⁻-type drift region 103 near the interface between the N⁻-type drift region 103 and the P-type collector region 101 in the same manner as in the case of the IGBT shown in Fig. 5. With this structure, formation of defective layers in the N⁻-type drift region 103 by irradiation of protons can be suppressed to minimum.

Fig. 8 is a cross sectional view showing the main portion of a GTO thyristor. An N⁺-type buffer layer 202 is formed on a P-type anode-emitter region 201 and an N-type anode-base region 203 is formed on the N⁺-type buffer layer 202. The N-type anode-base region 203 and N⁺-type anode-base region 203 function as one region. A P-type cathode-base region 204 is formed on the N-type anode-base region 203. The P-type cathode-base region 204 is formed to have mesa portions on its surface and N⁺-type cathode-emitter regions 205 are formed in the respective mesa portions. Cathode electrodes 206 which are commonly connected are formed on the respective N⁺-type cathode-emitter regions 205. Gate electrodes 207 which are commonly connected are formed on the concave portions of the P-type cathode-base region 204. Further, an anode electrode 208 is formed on the rear surface of the P-type anode-emitter region 201.

For example, the carrier-lifetime is controlled by irradiating protons into the GTO thyristor of the above construction. In the same manner as in the first embodiment, a low carrier-lifetime layer 110 having the peak of the number of stopped protons, that is, the peak of the number of recombination centers of carriers is formed in the N⁺-type buffer layer 202. As a result, the carrier-lifetime can be controlled without lowering the withstanding voltage of the device.

When the dose amount of protons is increased, the peak of the number of recombination centers of carriers may be set in position which is deviated from the center in the depth direction of the N⁺-type buffer layer 202 towards the P-type anode-emitter region 201 in the same manner as in the first embodiment. On the other hand, when the dose amount is decreased, the peak of the number of recombination centers of carriers may be set in position which is deviated from the center in the depth direction of the N⁺-type buffer layer 202 towards the N-type cathode-base region 203.

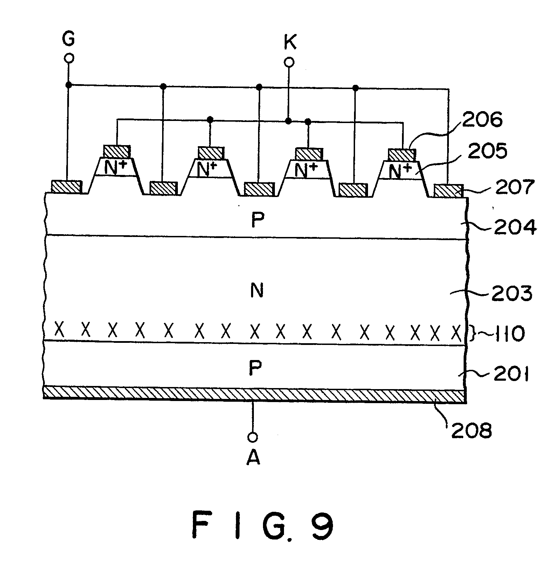

As shown in Fig. 9, when the N⁺-type buffer layer 202 is not formed in the GTO thyristor, the peak of the number of recombination centers of carriers may be set in that part of the N-type anode-base region 203 which lies near the interface between the N-type anode-base region 203 and the P-type anode-emitter region 201 in the same manner as shown in Figs. 5 and 7. With this structure, formation of defective layers in the N-type anode-base region 203 by irradiation of protons can be suppressed to minimum.

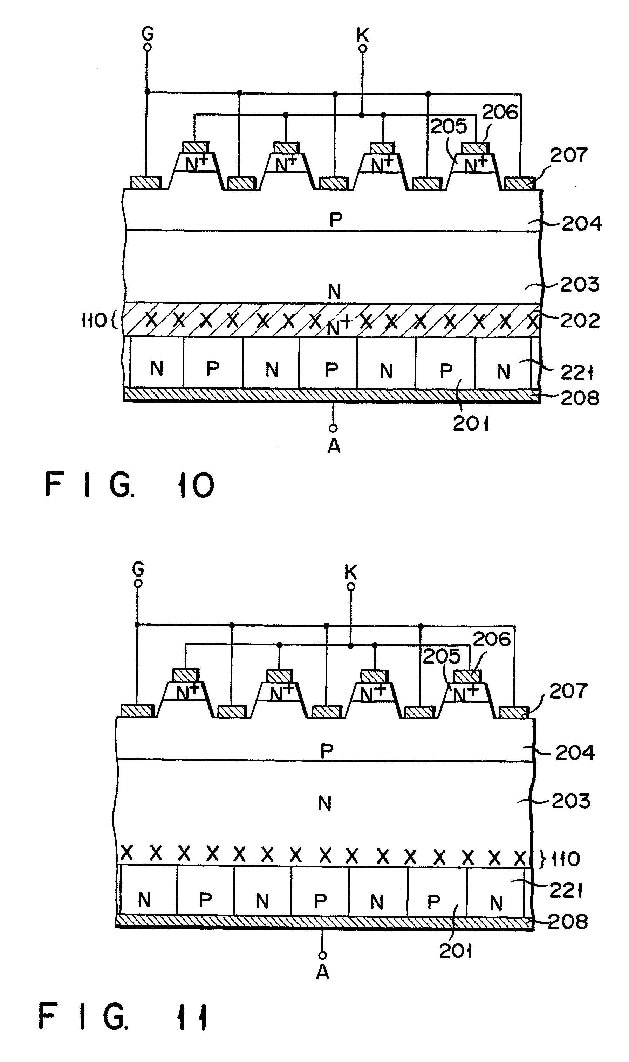

Fig. 10 is a cross sectional view showing the main portions of the anode short type GTO. In Fig. 10, those portions which are the same as the elements shown in Fig. 8 are denoted by the same reference numerals and the explanation thereof is omitted. That is, the anode sort type GTO is similar to the GTO of Fig. 8 except that a short region 221 for short-circuiting the anode electrode 208 to the N⁺-type buffer layer 202 and the anode-base region 203 is formed in the P-type anode-emitter region 201.

With the above construction, sweep-off time for the minority carriers (in this example, holes) injected from the P-type anode-emitter region 201 can be shortened, and as a result, the turn-off time becomes shorter, thus further enhancing the switching operation speed.

The GTO is different from that of Fig. 8 only in the above-described respect, and the basic operation, effect and modifications are substantially the same as those of the GTO shown in Fig. 8. Therefore, as shown in Fig. 11, it is not always necessary to form the N⁺-type buffer layer 202 in the anode short type GTO. In this case, the peak of the number of stopped portions (low carrier-lifetime layer 110) may be formed in the N-type anode-base region 203 near the interface between the N-type anode-base region 203 and the P-type anode-emitter region 201 in the same manner as in the case of the GTO shown in Fig. 9. With this structure, formation of defective layers in the N-type anode-base region 203 by irradiation of portions can be suppressed to minimum.

With the semiconductor device according to the first to forth embodiments described above, since the number of defective layers formed by irradiating high-energy particles having a relatively large mass into the N-type drift region (in the case of IGBT) or N-type anode-base region (in the case of thyristor) can be reduced, extension of a depletion layer will not be prevented even if a high voltage is applied to the device, so that the withstanding voltage characteristic of the device will not be deteriorated. Further, irradiation with high dose amount can be effected, the switching operation speed can be further enhanced, and a low carrier-lifetime layer can be selectively formed in a desired depth of the silicon substrate so that a preferable ON-state voltage characteristic can be obtained. Further, since control of the carrier-lifetime by irradiation of high-energy particles can be effected even in the final step of the device manufacturing process unlike the heavy metal implanting method and the like, the controllability is high and it is possible to increase the dose amount or effect the control operation from the beginning again.

In Figs. 5 to 11, an example in which protons are used as the high-energy particles, but like the embodiment of Fig. 2, a particles, heavy hydrogen, hydrogen molecule ions ($H2^+$) or particles which have a sufficiently large mass so as to be stopped in the semiconductor substrate can be used.

As described above, according to this invention, a semiconductor device in which the switching operation speed can be enhanced without lowering the withstanding voltage of the device and which has an excellent trade-off between the switching characteristic and the ON-state voltage characteristic can be provided.

Reference signs in the claims are intended for better understanding and shall not limit the scope.

## Claims

1. A bipolar type semiconductor device comprising a first semiconductor region (101, 201) of a first conductivity type;
   a second semiconductor region (102, 202) of a second conductivity type formed on the main surface of said first semiconductor region (101, 201);
   a third semiconductor region (103, 203) of the second conductivity type formed on said second semiconductor region (102, 202);
   a fourth semiconductor region (104, 204) of the first conductivity type formed in at least part of the main surface area of said third semiconductor region (103, 203); and
   a fifth semiconductor region (105, 205) of the second conductivity type formed in at least part of the main surface area of said fourth semiconductor region (104, 204), characterized in that a low carrier-lifetime layer (110) having the peak of the number of recombination centers of carriers is formed in said second semiconductor region (102, 202).

2. A semiconductor device according to claim 1, characterized by further comprising a first electrode (109) formed on the rear surface of said first semiconductor region (101);
   a first insulation film (106) formed on a first area of the main surfaces of said third, fourth and fifth semiconductor regions (103; 104; 105);
   a control electrode (107) formed on said first insulation film (106);
   a second insulation film (120) formed on an exposed portion of said control electrode (107); and
   a second electrode (108) formed on a second area of said second insulation film (120) and the main surfaces of said fourth and fifth semiconductor regions (104; 105) which is different from said first area.

3. A semiconductor device according to claim 2, characterized in that said first semiconductor region (101) is a collector region, said second semiconductor region (102) is a buffer layer, said third semiconductor region (103) is a drift region, said fourth semiconductor region (104) is a base region, said fifth semiconductor region (105) is a emitter region, said first electrode (109) is a collector electrode, said control electrode (107) is a gate electrode, and said second electrode (108) is a emitter electrode.

4. A semiconductor device according to claim 2, characterized by further comprising a short-circuit region (121) of the second conductivity type formed in said first semiconductor region (101), for short-circuiting said second and third semiconductor regions (102; 103) to said first electrode (109).

5. A semiconductor device according to claim 1, characterized by further comprising a first electrode (208) formed on the rear surface of said first semiconductor region (201), a control electrode (207) formed on the surface of part of said fourth semiconductor region (204) and a second electrode (206) formed on the surface of said fifth semiconductor region (205).

6. A semiconductor device according to claim 5, characterized in that said first semiconductor region (201) is an anode-emitter region, said second semiconductor region (202) is a buffer layer, said third semiconductor region (203) is an anode-base region, said fourth semiconductor region (204) is a cathode-base region, said fifth semiconductor region (205) is a cathode-emitter region, said first electrode (208) is an anode electrode, said control electrode (207) is a gate electrode, and said second electrode (206) is a cathode electrode.

7. A semiconductor device according to claim 5, characterized by further comprising a short-circuit region (221) of the second conductivity type formed in said first semiconductor region (201), for short-circuiting said second and third semiconductor region (202, 203) to said first electrode (208).

8. A bipolar type semiconductor device comprising a first semiconductor region (101, 201) of a first conductivity type;
    a second semiconductor region (103, 203) of a second conductivity type formed on the main surface of said first semiconductor region (101, 201);
    a third semiconductor region (104, 204) of the first conductivity type formed in at least part of the main surface area of said second semiconductor region (103, 203); and
    a fourth semiconductor region (105, 205) of the second conductivity type formed in at least part of the main surface area of said third semiconductor region (104, 204);
    characterized in that a low carrier-lifetime layer (110) having the peak of the number of recombination centers of carriers is formed in that part of said second semiconductor region (103, 203) which lies near the junction between said first semiconductor region (101, 201) and said second semiconductor region (103, 203).

9. A semiconductor device according to claim 1 or 8, characterized in that said low carrier-lifetime layer (110) is formed by irradiating high-energy particles.

10. A semiconductor device according to claim 9, characterized in that said high-energy particles are irradiated from the rear surface side of said first semiconductor region (101, 201).

11. A semiconductor device according to claim 9, characterized in that said high-energy particles are selected from a group consisting of protons, α particles, heavy hydrogen, and hydrogen molecule ions.

12. A semiconductor device according to claim 8, characterized by further comprising a first electrode (109) formed on the rear surface of said first semiconductor region (101);
    a first insulation film (106) formed on a first area of the main surfaces of said second, third and fourth semiconductor regions (103; 104; 105);
    a control electrode (107) formed on said first insulation film (106); a second insulation film (120) formed on an exposed portion of said control electrode (107); and
    a second electrode (108) formed on a second area of said second insulation film (120) and the main surfaces of said third and fourth semiconductor regions (104; 105) which is different from said first area.

13. A semiconductor device according to claim 12, characterized in that said first semiconductor region (101) is a collector region, said second semiconductor region (103) is a drift region, said third semiconductor region (104) is a base region, said fourth semiconductor region (105) is a emitter region, said first electrode (109) is a collector electrode, said control electrode (107) is a gate electrode, and said second electrode (108) is a emitter electrode.

14. A semiconductor device according to claim 12, characterized by further comprising a short-circuit region (121) of the second conductivity type formed in said first semiconductor region (101), for short-circuiting said second semiconductor region (103) to said first electrode (109).

15. A semiconductor device according to claim 8, characterized by further comprising a first electrode (208) formed on the rear surface of said first semiconductor region (201), a control electrode (207) formed on the surface of part of said third semiconductor region (204) and a second electrode (206) formed on the surface of said fourth semiconductor region (205).

16. A semiconductor device according to claim 15, characterized in that said first semiconductor region (201) is an anode-emitter region, said second semiconductor region (203) is an anode-base region, said third semiconductor region (204) is a cathode-base region, said fourth semiconductor region (205) is a cathode-emitter region, said first electrode (208) is an anode electrode, said control electrode (207) is a gate electrode, and said second electrode (206) is a cathode electrode.

**17.** A semiconductor device according to claim 15, characterized by further comprising a short-circuit region (221) of the second conductivity type formed in said first semiconductor region (201), for short-circuting said second semiconductor region (203) to said first electrode (208).

RELATION BETWEEN WITHSTANDING
VOLTAGE AND DOSE AMOUNT

F I G. 1

F I G. 2

EP 0 430 237 A1

$tF - V_{CE(SAT)}$ TRADE-OFF

FALL-TIME $tF$ [$\mu s$]

SATURATION VOLTAGE BETWEEN COLLECTOR AND EMITTER $V_{CE}$(SAT) [V]

(CURRENT DENSITY AT THE TIME OF 1.2A/mm$^2$)
RELATION BETWEEN FALL TIME AND SATURATION VOLTAGE BETWEEN COLLECTOR AND EMITTER

F I G. 3

RELATION BETWEEN WITHSTANDING VOLTAGE
AND ACCELERATION VOLTAGE FOR PROTONS

RELATION BETWEEN STOPPING DISTANCE
AND ACCELERATION VOLTAGE FOR PROTONS

# F I G. 4

F I G. 5

F I G. 6

F I G. 7

F I G. 8

14

F I G. 9

F I G. 10

F I G. 11

European
Patent Office

**EUROPEAN SEARCH
REPORT**

Application Number

**EP 90 12 2850**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 297 325  (MITSUBISHI DENKI)<br>* figures; pages 3,4; claims * | 1,5-7,<br>9-11 | H 01 L 29/32 |
| Y |  | 4,14-17 |  |
| X | US-A-4 752 818  (T. KUSHIDA et al.)<br>* figures 1,3-9; columns 2-12 * | 1,8-11 |  |
| X | FR-A-2 625 043  (MATSUSHITA ELECTRIC)<br>* pages 6-16; figures 4-7 * | 8,9,11-13 |  |
| X | EP-A-0 327 316  (TOSHIBA)<br>* whole document * | 1-3,8,12,<br>13 |  |
| Y |  | 4,14-17 |  |
| X | PATENT ABSTRACTS OF JAPAN vol. 10, no. 54<br>(E-385)(2111), 4 March 1986;<br>& JP - A - 60207376 (TOYODA CHUO KENKYOSHO K.K.)<br>18.10.1985<br>* abstract; figure * | 8 |  |
| A | DE-A-3 339 393  (LICENTIA PATENT-<br>VERWALTUNGS-GMBH)<br>* whole document * | 1,8 | TECHNICAL FIELDS SEARCHED (Int. Cl.5)<br><br>H 01 L |

The present search report has been drawn up for all claims

| Place of search | Date of completion of search | Examiner |
|---|---|---|
| Berlin | 06 February 91 | JUHL A. |